# FASCICULE DE BREVET EUROPEEN

(11) **EP 0 581 669 B1**
(45) Date de publication et mention de la délivrance du brevet: **23.04.1997**
(21) Numéro de dépôt: 93401946.4
(22) Date de dépôt: 27.07.1993
(51) Int. Cl.: H01R 43/20, H05K 3/30

(54) **Procédé et dispositif pour montage de composants à bornes coudées**
Verfahren und Vorrichtung zur Montage von Bauelementen mit gebogenen Anschlussklemmen
Process and device for mounting components with bended terminals

(30) Priorité: 31.07.1992 FR 9209576
(43) Date de publication de la demande: 02.02.1994
(73) Titulaire: AMPHENOL SOCAPEX, 92403 Courbevoie (FR)
(72) Inventeur: Cottet, Jacques, F-74250 Viuz en Sallaz (FR); Servoz, Serge, F-74500 Lugrin (FR)
(74) Mandataire: Dronne, Guy

(56) Documents cités:
- US-A- 4 611 399

## Description

La présente invention a pour objet un procédé et un dispositif pour le montage de composants à bornes de contact coudées dans les trous métallisés d'une carte imprimée.

Le montage d'un composant sur une carte imprimée par introduction de ses bornes de contact dans les trous métallisés de la carte avant brasage des bornes devient une opération particulièrement délicate en raison de la miniaturisation de plus en plus grande des composants, de l'augmentation sensible du nombre de bornes, de leur densité et de la réduction de leur section qui en réduit en même temps la rigidité.

Parmi les composants les plus délicats à monter sur une carte imprimée figurent les connecteurs prévus pour être montés sur des cartes filles, ces connecteurs comportant des bornes de contact coudées prévues pour être insérées dans des trous étamés de la carte fille, ces contacts disposés à proximité d'un bord de la carte étant en très grand nombre et très proche les uns des autres.

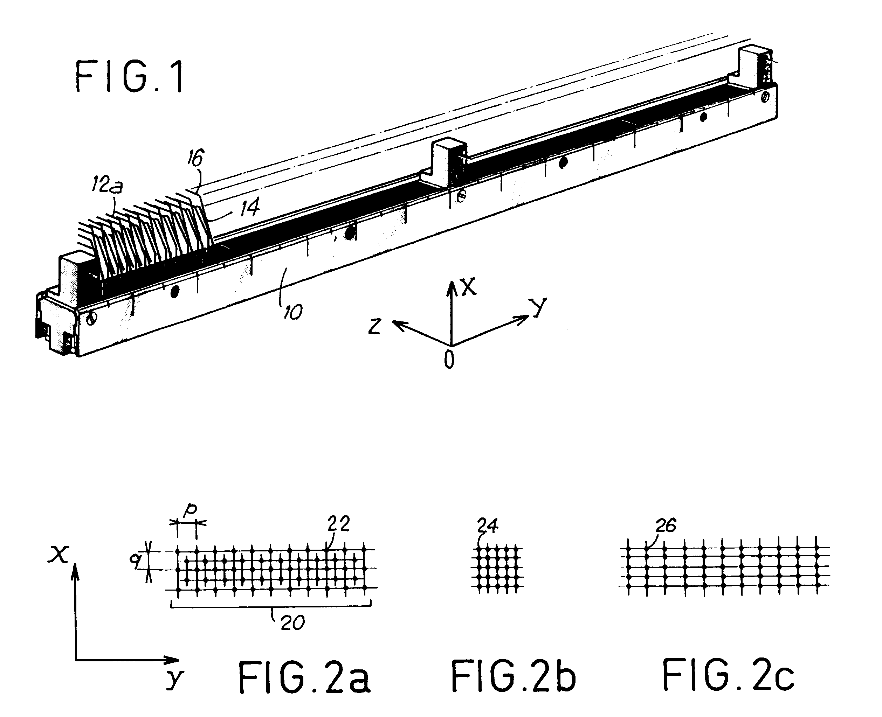

La figure 1 montre un connecteur à bornes de contact coudées. Il est constitué par un corps allongé 10 destiné à être fixé sur un bord de la carte imprimée. Le corps 10 est traversé par des bornes de contact constituées par des conducteurs électriques dont on a représenté l'extrémité libre 12a qui est destinée à être introduite dans les trous métallisés de la carte. Comme on le voit, les bornes de contact sont coudées, c'est-à-dire qu'elles comportent une première portion 14 qui est sensiblement perpendiculaire à la face du corps 10 (axe OX) et une portion coudée à angle droit 16 qui est sensiblement parallèle au corps 10 du connecteur -axe OZ).

Comme on le voit, les différentes bornes de contact 12 sont disposées dans des plans perpendiculaires à la longueur du corps 10 du connecteur.

Sur les figures 2a à 2c, on a montré différentes configurations possibles de trous métallisés réalisés dans une carte de circuit imprimé portant la référence générale 20.

Dans le cas de la figure 2a, les trous métallisés 22 sont dits en quinconce. Ils sont répartis selon des lignes parallèles à la direction Y et des colonnes parallèles à la direction X. Le pas entre deux trous métallisés consécutifs est égal à P selon la direction Y et il est égal à q selon la direction X.

La figure 2b montre une disposition de trous métallisés 24 dite en carré et la figure 2c montre une disposition de trous métallisés 26 dite en rectangle.

Comme on peut le remarquer de toute manière les trous métallisés 22, 24 ou 26 sont globalement disposés selon des lignes Y et des colonnes X. Il va de soi que les extrémités 12a des bornes de contact du connecteur reproduisent la même configuration spatiale que celle des trous métallisés 22, 24 ou 26.

On comprend aisément que, lorsque les pas des trous métallisés q et p et donc ceux des extrémités des bornes de contact 12a sont réduits, l'introduction directe des bornes de contact dans les trous métallisés est très difficile sinon impossible en raison de la relative flexibilité des extrémités et des tolérances dans leur positionnement relatif.

Pour résoudre ce problème, on a déjà décrit dans le brevet français No. 2 605 175 au nom de la demanderesse un outillage permettant le guidage des extrémités des bornes de contact pour faciliter l'introduction de celles-ci dans les trous métallisés.

Cependant, l'outillage décrit dans ce brevet est très bien adapté au cas des composants ou connecteurs à bornes droites, c'est-à-dire typiquement des connecteurs à monter sur un fond de panier qui est le plus souvent totalement dépourvu d'autres composants.

Cependant, cet outil n'est pas adapté au cas des composants ou des connecteurs à bornes coudées illustrés sur la figure 1, c'est-à-dire typiquement au cas des connecteurs à monter sur les cartes filles qui sont, en général, déjà équipées de divers composants électroniques lorsque l'on doit procéder au montage du connecteur sur la carte.

Le document US-A-4 611 399 décrit un outillage permettant de monter des bornes coudées. Cependant, cet outillage qui comporte d'une part un ensemble formant peigne et d'autre part une pluralité de tiges de guidage parallèles n'assure pas, lors de sa mise en place en deux étapes par rapport aux extrémités libres des bornes un bon guidage de celles-ci.

Un objet de la présente invention est de fournir un dispositif de montage et un procédé de montage qui permettent effectivement le guidage des extrémités des bornes de contact coudées de composants ou de connecteurs dans les trous métallisés d'une carte imprimée, même si d'autres composants sont déjà fixés sur la carte imprimée.

Pour atteindre ce but, le dispositif pour le montage dans les trous métallisés d'une carte imprimée de composants électroniques à bornes coudées dont les extrémités sont disposées selon un arrangement régulier en lignes et en colonnes parallèles, lesdites bornes s'étendant selon la direction des colonnes, comprenant :
un ensemble de guidage formant peigne constitué par une pluralité de dents parallèles entre elles et définissant entre elles des fentes, chaque fente étant apte à recevoir les bornes d'une même colonne. et
une pluralité d'éléments allongés caractérisé en ce que chaque dent est munie d'une pluralité d'orifices, les orifices correspondants étant alignés selon la direction des lignes, chaque élément allongé étant apte à être introduit dans les orifices des dents disposés selon une même ligne, chaque élément allongé étant disposé entre une borne d'une colonne et la borne contiguë de la même colonne, par quoi, lorsque l'ensemble desdites bornes est mis en place dans ledit dispositif, l'extrémité de chaque borne est entourée par des portions de deux dents adjacentes et par des portions de deux éléments allongés adjacents.

On comprend qu'avec un tel dispositif de montage, l'encombrement de l'ensemble de montage est sensiblement égal à celui de la zone comportant les trous métallisés. Il est donc possible effectivement de réaliser le montage même si des composants électroniques sont déjà fixés sur la carte imprimée.

En outre, on comprend que, grâce au caractère amovible des éléments allongés, il est possible d'extraire ceux-ci pour déplacer l'ensemble du composant perpendiculairement au plan de la carte afin de faire pénétrer entièrement les extrémités des bornes de contact dans les trous métallisés en positionnant ainsi correctement le connecteur ou le composant par rapport à ladite carte.

Selon une autre caractéristique de l'invention, l'ensemble de guidage comporte plusieurs ensembles modulaires formant peigne qui peuvent être associés entre eux pour adapter sa longueur selon la direction des lignes aux dimensions du composant à monter sur la carte imprimée.

On obtient ainsi un dispositif qui peut s'adapter à différentes longueurs de composants à condition que les pas des extrémités des bornes de contact selon la direction des lignes et des colonnes soient les mêmes.

Un autre objet de l'invention est de fournir un procédé de montage d'un composant électronique comportant une pluralité de bornes coudées dans les trous métallisés d'une carte imprimée, les extrémités desdites bornes coudées étant disposées selon un arrangement régulier en lignes et en colonnes parallèles, lesdits bornes s'étendant selon la direction des colonnes, caractérisé en ce qu'il comporte les étapes suivantes :
on dispose les bornes disposées selon une même colonne dans les fentes parallèles d'un ensemble de guidage, lesdites fentes étant séparées par des dents parallèles, de telle manière que les extrémités des bornes fassent saillie hors des extrémités desdites dents ;
on introduit des éléments allongés dans une pluralité de trous alignés ménagés dans lesdites dents, de telle manière que lesdits éléments allongés séparent les extrémités de deux bornes adjacentes d'une même colonne,
on positionne ledit ensemble de guidage par rapport à ladite carte, de telle manière que lesdites extrémités des bornes pénètrent au moins partiellement dans lesdits trous métallisés,
on extrait lesdits éléments allongés desdits orifices,
on déplace relativement ladite carte par rapport audit composant perpendiculairement au plan de ladite carte pour faire complètement pénétrer les extrémités desdites bornes dans lesdits trous métallisés,
on solidarise ladite carte et ledit composant, et
on sépare ledit ensemble de montage et la carte avec son composant.

D'autres caractéristiques et avantages de la présente invention apparaîtront mieux à la lecture de la description qui suit de plusieurs modes de réalisation de l'invention donnés à titre d'exemples non limitatifs. La description se réfère aux figures annexées sur lesquelles :
- la figure 1, déjà décrite, est une vue en perspective d'un connecteur à bornes de contact coudées ;
- les figures 2a à 2c, déjà décrites, montrent différentes configurations de trous métallisés sur une carte imprimée ;
- la figure 3 montre en perspective une partie d'un ensemble formant peigne ;
- la figure 4 montre une vue partielle d'un élément allongé du dispositif de montage ;
- les figures 5 et 6 illustrent en coupe verticale les différentes phases de mise en place des bornes coudées dans l'ensemble formant peigne et la mise en place de la carte imprimée par rapport au dispositif de montage ;
- la figure 7 est une vue d'ensemble en perspective d'un dispositif modulaire complet de montage des bornes de composants ;
- la figure 8 montre un cas particulier de montage de composants sur une carte imprimée.

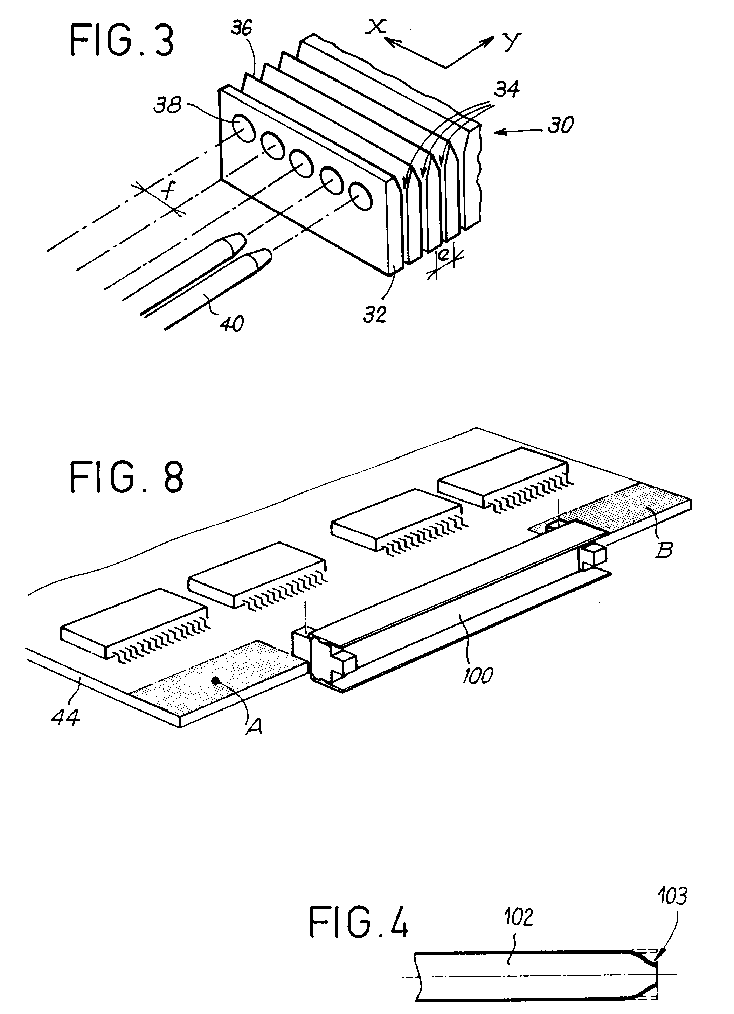

En se référant tout d'abord aux figures 3 à 6, on va décrire le principe du dispositif de montage de composants.

Le dispositif de montage est essentiellement constitué par un élément de guidage 30 en forme de peigne.

L'élément 30 est constitué par des dents 32 qui sont parallèles entre elles et parallèles à la direction X. Les dents sont séparées par des fentes 34. L'écartement e entre deux dents consécutives est bien sûr égal au pas p entre deux trous métallisés consécutifs selon la direction Y.

Afin de faciliter la mise en place des bornes coudées entre les dents 32, l'extrémité libre de celles-ci a la forme d'un biseau 36.

Comme on le voit mieux sur la figure 3, les dents sont munies d'orifices 38 disposés légèrement en-dessous de leur extrémité en forme de biseau 36. Les trous correspondants des dents sont alignés selon la direction Y. L'écartement e entre les axes de deux trous adjacents est égal au pas q des trous métallisés selon la direction X.

L'élément de guidage 30 est complété par des éléments allongés en forme de tiges 40 qui peuvent être introduites dans les trous alignés 38 ménagés dans les dents. Selon un mode préféré, l'extrémité des tiges 40 est légèrement tronconique pour faciliter leur insertion dans les orifices 38. On comprend que, lorsque l'ensemble des tiges 40 a été introduit dans les orifices 38 des dents 32, cette structure définit un quadrillage d'éléments de guidage de pas respectif p et q.

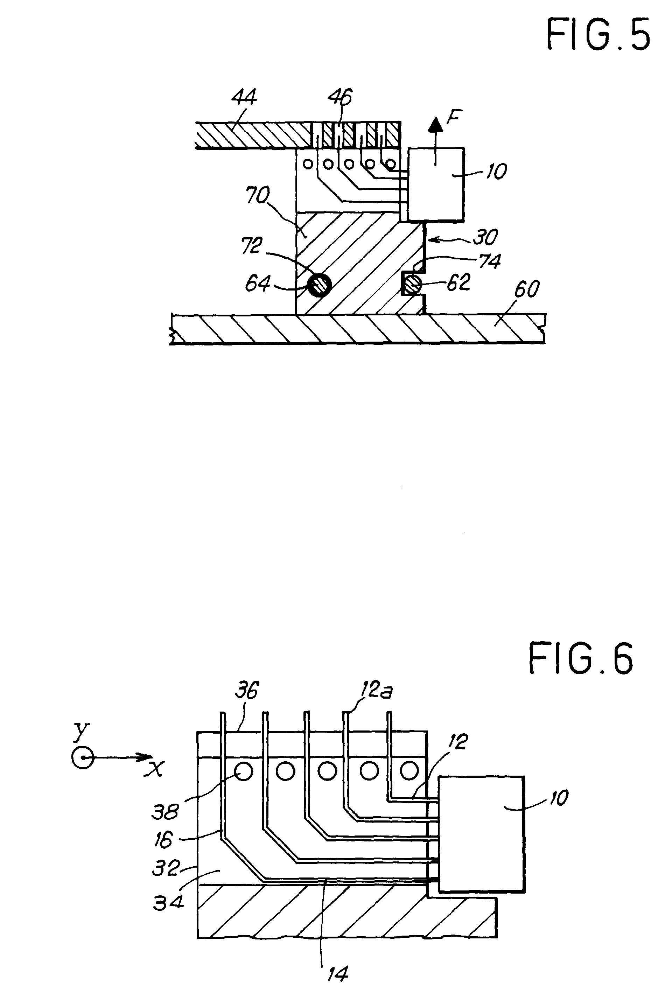

La figure 6 montre la mise en place des bornes coudées d'un connecteur sur l'ensemble de guidage. Le corps du connecteur 10 est placé le long d'une des extrémités de l'ensemble de guidage 30. Les différentes bornes coudées 12 du connecteur disposées selon une même direction X pénètrent toutes dans une même fente 34 entre deux dents consécutives 32. L'ensemble des bornes pénètre ainsi dans l'ensemble des fentes 34 de la pièce de guidage 30.

Comme le montre la figure 6, les orifices 38 sont disposés à proximité du bord libre 36 des dents de telle manière que les trous 38 soient tous disposés au-dessus des premières portions 14 des bornes de contact coudées 12 lorsque les bornes ont été mises en place dans les fentes. On introduit ensuite les tiges 40 dans les ensembles de trous 38. La profondeur des fentes 34 est déterminée de telle manière que, après la mise en place du connecteur, les extrémités 12a des bornes de contact fassent légèrement saillie au-dessus des bords 36 des dents. On comprend qu'ainsi, les extrémités 12a des bornes de contact sont maintenues et guidées par la coopération des dents 32 et des tiges 40.

Comme le montre la figure 5, dans l'étape suivante, on positionne la carte imprimée 44 sur laquelle le connecteur 10 doit être monté par rapport à l'ensemble de guidage 30 par des moyens qui seront décrits ultérieurement. Grâce à ce positionnement, les trous métallisés 46 de la carte imprimée 44 se trouvent en regard des extrémités 12a des bornes coudées. Ces extrémités pénètrent légèrement dans les trous métallisés 46.

Dans l'étape suivante, on extrait les tiges 40 des trous 38. Il est alors possible de soulever l'ensemble du connecteur selon la direction de la flèche F, c'est-à-dire perpendiculairement au plan de la carte imprimée 44 de telle manière que les extrémités 12a des bornes de contact pénètrent totalement dans les orifices métallisés 46. Il ne reste plus alors qu'à solidariser mécaniquement le corps du connecteur sur la carte imprimée pour terminer le montage.

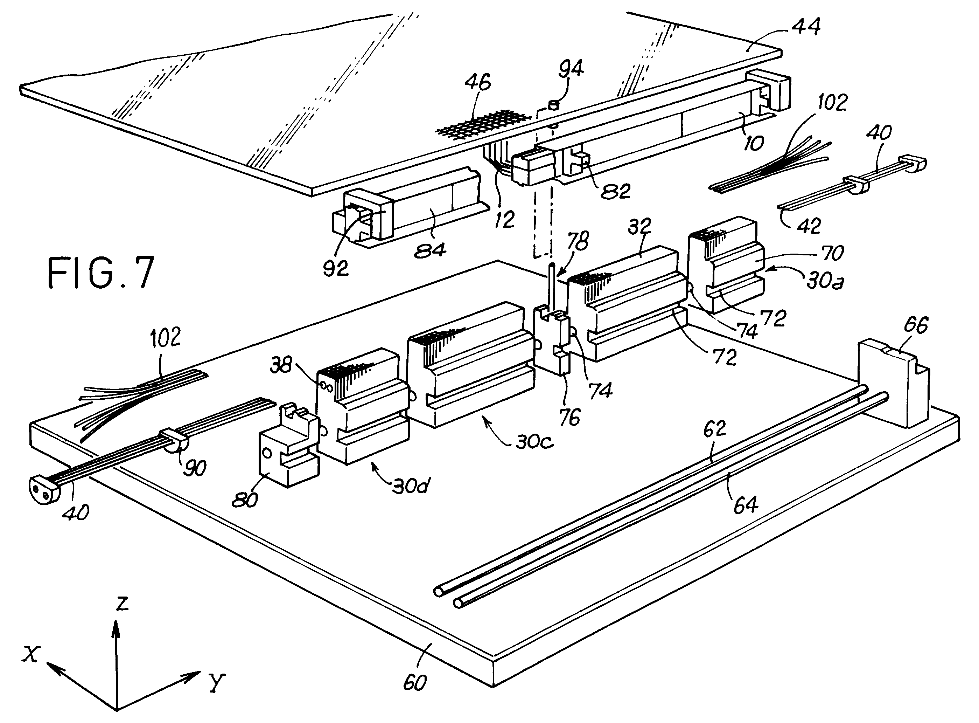

En se référant maintenant à la figure 7, on va décrire plus en détails un exemple complet de réalisation du dispositif de montage. Ce dispositif se distingue essentiellement de celui qui a été décrit précédemment par le fait qu'il est modulaire. Plus précisément, l'ensemble de guidage est constitué par plusieurs modules qui peuvent être assemblés entre eux afin d'adapter la longueur, selon la direction Y, de l'ensemble de guidage à celle du connecteur ou du composant à monter sur la carte imprimée.

L'outil de montage comprend un socle 60 sur lequel sont fixées des tiges de guidage 62 et 64 par l'intermédiaire d'un support fixe 66. Les tiges 62 et 64 sont parallèles à la direction Y. L'outil comprend également plusieurs ensembles de guidage 30a, 30b, 30c et 30d qui sont identiques à l'ensemble de guidage 30 des figures 5 et 6. Ils comportent chacun des dents 32 et des orifices 38. Ils ont des longueurs différentes selon la direction Y. Le corps 70 de chaque ensemble 30 est muni d'une rainure longitudinale 72 et d'un trou longitudinal 74. Lors de la préparation de l'outil, on engage les ensembles de guidage 30a, 30b, 30 et 30d sur les tiges de guidage 62 et 64 qui pénètrent la rainure 72 et le trou 74. Le nombre et la largeur des modules montés sur le socle 60 sont adaptés à la longueur du connecteur 10 à monter sur la carte imprimée 44. Lorsque les ensembles 30 sont montés sur le socle 60, tous les orifices 38 sont alignés selon la direction Y. On engage également entre les tiges 62 et 64 un support intermédiaire 76 qui est muni d'une tige 78 de positionnement de la carte 44, et un support d'extrémité 80 amovible. Lorsque les éléments convenables ont été engagés entre les tiges 62 et 64, ceux-ci sont immobilisés par des moyens de verrouillage non représentés qui peuvent consister en une vis. L'outil est alors prêt à être utilisé et il est adapté à la longueur du connecteur 10 à monter sur la carte 42.

Dans un premier temps, le connecteur 10 est monté sur l'outil de telle manière que les bornes de contact pénètrent dans les fentes 34 des ensembles de guidage 30a, 30b, 30c et 30d. Le guidage initial est réalisé par la coopération de la tige de guidage 78 de la pièce 76 avec un orifice de fixation du connecteur 10 sur la carte, cet orifice disposé sur la face postérieure du connecteur n'étant pas visible sur la figure. Le connecteur est introduit "à fond" jusqu'à ce qu'il arrive en butée basse sur le corps 70 des éléments de guidage 30a, 30b, 30c et 30d. Les bornes de contact 12 du connecteur sont alors dans la position représentée sur la figure 6.

Dans l'étape suivante, on introduit les tiges 40 dans les trous alignés des dents 32 des éléments de guidage 30a, 30b, 30c et 30d. Pour faciliter l'introduction des tiges 40, elles sont montées dans un curseur coulissant 90. Au début de l'insertion, le curseur 90 est proche des extrémités 42 des tiges 40. Au fur et à mesure de l'insertion des tiges dans les orifices 38, le curseur est repoussé par la face latérale du premier ensemble de guidage. Lorsque les deux séries de tiges 40 ont été complètement insérées, les extrémités 12a des bornes de contact 12 sont convenablement guidées.

Il reste alors à positionner la carte 44 par rapport à l'outil, c'est-à-dire par rapport au connecteur. Ce positionnement est, dans un premier temps, réalisé par la coopération de la tige 78 avec l'orifice de la pièce 94 introduite dans le trou de fixation de la carte et destiné à adapter le diamètre du trou de carte au diamètre de la tige 78. Cela laisse cependant la carte 42 libre selon la direction Z orthogonale aux directions X et Y, c'est-à-dire orthogonale au plan de la carte. L'immobilisation en rotation est obtenue, par exemple, à l'aide des éléments de positionnement 92 engagés aux extrémités du connecteur. Ces éléments 92 viennent en butée sur la tranche de la carte 44 lorsque la carte est abaissée. On abaisse la carte 44 selon la direction Z, ce qui permet à chaque extrémité de bornes de contact de pénétrer dans le trou métallisé correspondant 46. On retire alors les éléments de positionnement 92 de la carte.

Ensuite, on retire les deux séries de tiges 40 hors des ensembles de guidage 30a, 30b, 30c et 30d. Puis, par vissage des vis de fixation du connecteur de la carte 42 (non représentée), on provoque le rapprochement du connecteur de la carte, ce qui entraîne l'insertion complète des extrémités des bornes de contact 12 dans les trous métallisés 46 de la carte 44. Le montage du connecteur est ainsi terminé. Il ne reste plus qu'à retirer l'ensemble carte-connecteur de l'outil.

On comprend que l'insertion des tiges rigides 40 dans les ensembles de guidage 30 n'est possible que si, sur la carte, les zones disposées aux extrémités du connecteur sont dépourvues de composants. La figure 8 montre un cas où les zones A et B disposées aux extrémités du connecteur 100 à monter sont occupées par des composants. Dans ce cas, les tiges rigides 40 sont remplacées par des tubes flexibles 102 visibles sur la figure 7. Ces tubes 102 ont une souplesse suffisante pour s'adapter à la présence des composants dans les zones A et B de la carte. Afin de faciliter leur insertion, les extrémités des tubes présentent un rétreint 103 comme le montre la figure 4. Une fois qu'ils ont été insérés, les tubes 102 jouent le même rôle de guidage des extrémités des bornes de connexion que les tiges rigides 40.

## Revendications

1. Procédé de montage d'un composant électronique comportant une pluralité de bornes coudées dans les trous métallisés d'une carte imprimée, les extrémités desdites bornes coudées étant disposées selon un arrangement régulier en lignes et en colonnes parallèles, lesdits bornes s'étendant selon la direction des colonnes, caractérisé en ce qu'il comporte les étapes suivantes :
on dispose les bornes (12) disposées selon une même colonne dans les fentes parallèles (34) d'un ensemble de guidage (30), lesdites fentes étant séparées par des dents (32) parallèles, de telle manière que les extrémités des bornes fassent saillie hors des extrémités desdites dents ;
on introduit des éléments allongés (40, 102) dans une pluralité de trous (38) alignés ménagés dans lesdites dents, de telle manière que lesdits éléments allongés séparent les extrémités de deux bornes adjacentes d'une même colonne,
on positionne ledit ensemble de guidage (30) par rapport à ladite carte (44), de telle manière que lesdites extrémités des bornes pénètrent au moins partiellement dans lesdits trous métallisés (46),
on extrait lesdits éléments allongés desdits orifices,
on déplace relativement ladite carte par rapport audit composant (10) perpendiculairement au plan de ladite carte pour faire complètement pénétrer les extrémités desdites bornes dans lesdits trous métallisés,
on solidarise ladite carte et ledit composant, et
on sépare ledit ensemble de montage et la carte avec son composant.

2. Dispositif pour le montage dans les trous métallisés (46) d'une carte imprimée (44) de composants électroniques (10) à bornes coudées (12) dont les extrémités sont disposées selon un arrangement régulier en lignes (Y) et en colonnes (X) parallèles, lesdites bornes s'étendant selon la direction des colonnes comprenant :
un ensemble de guidage (30a, 30b, 30c, 30d) formant peigne constitué par une pluralité de dents (32) parallèles entre elles et définissant entre elles des fentes (34), chaque fente étant apte à recevoir les bornes d'une même colonne. et
une pluralité d'éléments allongés (40, 102) caractérisé en ce que chaque dent est munie d'une pluralité d'orifices (38), les orifices correspondants étant alignés selon la direction des lignes, chaque élément allongé étant apte à être introduit dans les orifices des dents disposés selon une même ligne, chaque élément allongé étant disposé entre une borne d'une colonne et la borne contiguë de la même colonne, par quoi, lorsque l'ensemble desdites bornes est mis en place dans ledit dispositif, l'extrémité de chaque borne est entourée par des portions de deux dents adjacentes et par des portions de deux éléments allongés adjacents.

3. Dispositif de montage selon la revendication 2, caractérisé en ce que ledit ensemble de guidage (30) comprend une pluralité de modules de guidage (30a, 30b, 30c, 30d) constitué chacun par un corps (70), une pluralité de dents (32) parallèles entre elles définissant entre elles des fentes (34), lesdites dents étant munies d'orifices (38) aptes à recevoir lesdits éléments allongés (40, 102), un socle (60) et des moyens (62, 64, 66) pour solidariser lesdits modules de guidage sur ledit socle de telle manière que les orifices (38) correspondants desdits modules soient alignés selon la direction des lignes (Y).

4. Dispositif de montage selon l'une quelconque des revendications 2 et 3, caractérisé en ce que lesdits éléments allongés sont des tiges rigides (40).

5. Dispositif de montage selon l'une des revendications 2 et 3, caractérisé en ce que lesdits éléments allongés sont des tubes flexibles (102).

## Patentansprüche

1. Verfahren zum Einbau eines elektronischen Bauteils mit einer Mehrzahl von Winkelklemmen in die metallkaschierten Löcher einer Leiterplatte, wobei die Enden der Winkelklemmen in einer regelmäßigen Anordnung aus parallelen Linien und Spalten liegen, und wobei die Klemmen in Richtung der Spalten verlaufen, dadurch gekennzeichnet, daß es folgende Schritte umfaßt:
die in einer gleichen Spalte in parallelen Schlitzen (34) einer Führungseinheit (30) angeordneten Klemmen (12) werden so angebracht,
wobei die Schlitze durch parallele Zahnglieder (32) getrennt sind, daß die Enden der Klemmen aus den Enden der Zahnglieder hervorstehen,
Langstifte (40, 102) werden in einer Mehrzahl von fluchtenden, in den Zahngliedern vorgesehenen Löchern (38) so eingeführt, daß die Langstifte die Enden von zwei benachbarten Klemmen gleicher Spalte voneinander trennen,
die Führungseinheit (30) wird so zur Platte (44) angeordnet, daß die Enden der Klemmen zumindest teilweise in die metallkaschierten Löcher (46) dringen,
die Langstifte werden aus den Löchern herausgezogen,
die Platte wird so zum elektronischen Bauteil (10) senkrecht zur Ebene der Platte gelegt, daß die Enden der Klemmen ganz in die metallkaschierten Löcher dringen,
die Platte und das Bauteil werden miteinander befestigt, und
die Baueinheit und die Platte mit dem elektronischen Bauteil werden voneinander getrennt.

2. Vorrichtung zum Einbau von elektronischen Bauteilen (10) mit Winkelklemmen (12) in metallkaschierten Löchern (46) einer Leiterplatte (44), wobei die Enden der Winkelklemmen in einer regelmäßigen Anordnung aus parallelen Linien (Y) und Spalten (X) liegen, und wobei die Klemmen in Richtung der Spalten verlaufen, mit einer Führungseinheit (30a, 30b, 30c, 30d) in Form eines Kamms, der aus einer Mehrzahl von zueinander parallelen Zahngliedem (32) besteht, die zwischen sich Schlitze (34) definieren, wobei jeder Schlitz die Klemmen einer gleichen Spalte aufnehmen kann, und mit
einer Mehrzahl von Langstiften (40, 102),
dadurch gekennzeichnet, daß jedes Zahnglied eine Mehrzahl von Löchern (38) aufweist, wobei die entsprechenden Löcher in Richtung der Linien ausgerichtet sind, wobei jeder Langstift in die Löcher der in einer Linie angeordneten Zahnglieder eingeführt werden kann, wobei jeder Langstift zwischen einer Klemme einer Spalte und der angrenzenden Klemme der gleichen Spalte angeordnet ist, wodurch, wenn die Gesamtheit der Klemmen in die Vorrichtung eingesetzt ist, das Ende einer jeden Klemme von Teilen zweier benachbarter Zahnglieder und von Teilen zweier benachbarter Langstifte umschlossen ist.

3. Einbauvorrichtung nach Anspruch 2, dadurch gekennzeichnet, daß die Führungseinheit (30) eine Mehrzahl von Führungsmodulen (30a, 30b, 30c, 30d) aufweist, von denen jedes aus einem Körper besteht (70), wobei eine Mehrzahl von zueinander parallelen Zahngliedern (32) zwischen sich Schlitze (34) definieren, wobei die Zahnglieder mit Löchern (38) versehen sind, die die Langstifte (40, 102) aufnehmen können, einen Sockel (60) und Mittel (62, 64, 66) um die Führungsmodule auf dem Sockel so zu befestigen, daß die entsprechenden Löcher (38) der Module in Richtung der Linien (Y) ausgerichtet sind.

4. Einbauvorrichtung nach einem der Ansprüche 2 und 3, dadurch gekennzeichnet, daß die Langstifte starre Stifte (40) sind.

5. Einbauvorrichtung nach einem der Ansprüche 2 und 3, dadurch gekennzeichnet, daß die Langstifte biegsame Schläuche sind (102).

## Claims

1. A method of mounting an electronic component having a plurality of angled terminals in plated-through holes of a printed card, the ends of said angled terminals being disposed in a regular disposition of parallel rows and columns, said terminals extending in the column direction, the method being characterized in that it comprises the following steps:
the terminals (12) disposed in the same columns are disposed in corresponding parallel slots (34) of a guide assembly (30), said slots being separated by parallel teeth (32), in such a manner that the ends of the terminals project beyond the ends of said teeth;
elongate elements (40, 102) are inserted in a plurality of aligned orifices (38) formed in said teeth, in such a manner that said elongate elements separate the ends of two adjacent terminals in the same column;
said guide assembly (30) is positioned relative to said card (44) in such a manner that said terminal ends penetrate at least in part into said plated-through holes (46);
said elongate elements are withdrawn from said orifices;
said card is displaced relative to said component (10) perpendicular to the plane of said card so as to cause the ends of said terminals to penetrate fully into said plated-through holes;
the card is secured to said component; and
said mounting assembly is separated from the card together with its component.

2. The apparatus for mounting electronic components (10) having angled terminals (12) in plated-through holes (46) of a printed card (44), the ends of the terminals being disposed in a regular arrangement of parallel rows (Y) and columns (X), said terminals extending in the column direction, the apparatus comprising:
a comb-forming guide assembly (30a, 30b, 30c, 30d) constituted by a plurality of mutually parallel teeth (32) defining slots (34) between one another, each slot being suitable for receiving terminals in a same column; and
a plurality of elongate elements (40, 102), characterized in that each tooth is provided with a plurality of orifices (38), the corresponding orifices being in alignment in the row direction, each elongate element being suitable for being inserted into the orifices of the teeth that are disposed on the same row, each elongate element being disposed between a terminal of one column and an adjacent terminal in the same column, whereby the end of each terminal is surrounded, when all of said terminals are installed in said device, by portions of two adjacent teeth and by portions of two adjacent elongate elements.

3. The mounting apparatus according to claim 2, characterized in that said guide assembly (30) comprises a plurality of guide modules (30a, 30b, 30c, 30d) each constituted by a body (70), a plurality of mutually parallel teeth (32) defining slots (34) between one another, said teeth being provided with orifices (38) suitable for receiving said elongate elements (40, 102), a baseplate (60), and means (62, 64, 66) for securing said guide modules on said baseplate in such a manner that the corresponding orifices (38) of said modules are in alignment in the row direction (Y).

4. The mounting apparatus according to any one of claims 2 and 3, characterized in that said elongate elements are rigid rods (40).

5. The mounting apparatus according to one of claims 2 and 3, characterized in that said elongate elements are flexible tubes (102).
